(19) Europäisches Patentamt

European Patent Office

Office européen des brevets

(11) **EP 0 731 557 A1**

(12) **DEMANDE DE BREVET EUROPEEN**

(43) Date de publication:
**11.09.1996 Bulletin 1996/37**

(51) Int Cl.$^6$: **H03F 3/50**

(21) Numéro de dépôt: **96400347.9**

(22) Date de dépôt: **20.02.1996**

(84) Etats contractants désignés:
**DE FR GB NL**

(30) Priorité: **07.03.1995 FR 9502632**

(71) Demandeur: **THOMSON TUBES ELECTRONIQUES**
**92360 Meudon La Foret (FR)**

(72) Inventeurs:
- **Arques, Marc**
  **92402 Courbevoie Cedex (FR)**

- **Ducourant, Thierry**
  **92402 Courbevoie Cedex (FR)**

(74) Mandataire: **Simonnet, Christine et al**
**Thomson-CSF/SCPI**
**B.P. 329,**
**50, rue Jean-Pierre Timbaud**
**92402 Courbevoie Cedex (FR)**

(54) **Dispositif de recopie de tension à grande linéarité**

(57) L'invention concerne un dispositif de recopie d'une tension (Ve). Il comporte une paire de transistors MOS (T1,T2) en série, leurs sources (s1,s2) formant un point commun (A). La tension à recopier (Ve) est appliquée entre la grille (g1) du premier transistor MOS (T1) de la paire et une référence.

Des moyens (Ic) sont prévus pour injecter un flux d'électrons au point commun (A).

Une capacité de stockage (Cs) a une première borne reliée au drain (d2) du second transistor MOS (T2) et une seconde borne destinée à être polarisée. Des moyens (I) imposent un potentiel (Vd2) au drain (d2) du second transistor MOS (T2) puis le laissent varier de manière à ce que le flux d'électrons se stocke sur la capacité de stockage (Cs) tout en diminuant dans le second transistor MOS (T2) au bénéfice du premier (T1). La tension recopiée (Vs) est disponible après stabilisation entre la première borne de la capacité de stockage (Cs) et la référence.

Application notamment aux circuits de lecture de charges engendrées dans une matrice ou une barrette photosensibles.

FIG.2

## Description

La présente invention concerne un dispositif de recopie de tension à transistors MOS qui peut être utilisé notamment dans un dispositif à transfert de charges et plus particulièrement dans un dispositif de lecture de charges engendrées dans une matrice ou une barrette photosensibles.

Les dispositifs de recopie de tension à transistors MOS de type connu utilisent deux transistors MOS montés en série, l'un est monté en suiveur et l'autre en charge. Le drain du transistor de charge est relié à la source du transistor suiveur. La tension d'entrée à recopier est appliquée entre la grille du transistor suiveur et une référence et la tension de sortie recopiée prélevée entre le point commun entre les deux transistors MOS et la référence. La tension à recopier est généralement disponible sous une forte impédance qui peut même devenir infinie. On souhaite que la tension recopiée soit aussi proche que possible de la tension à recopier. Elle peut être utilisable sous faible impédance ou bien sous impédance infinie. On peut admettre un décalage fixe entre la tension recopiée et la tension à recopier.

On obtient une tension recopiée qui est égale à la tension à recopier diminuée d'un terme indépendant de la tension à recopier et de la tension de seuil du transistor MOS monté en suiveur. Au premier ordre cette tension de seuil peut être considérée comme une constante mais au deuxième ordre, elle est fonction de la tension appliquée sur la grille du transistor monté en suiveur et donc de la tension à recopier. Le décalage entre la tension recopiée et la tension à recopier n'est plus fixe et le circuit n'est pas linéaire.

Dans la pratique, pour une variation de la tension à recopier de l'ordre du volt, la non linéarité atteint plusieurs pourcents.

La présente invention vise à remédier à ces problèmes de non linéarité entre la tension recopiée et la tension à recopier.

Elle propose un dispositif de recopie de tension qui transmet les variations de la tension à recopier aussi fidèlement que possible sur toute la gamme d'utilisation.

Pour cela le dispositif de recopie de tension selon l'invention comporte: une paire de transistors MOS ayant un point commun au niveau de leurs sources, des moyens pour injecter un flux d'électrons au point commun, une capacité de stockage dont une première borne est reliée au drain du second transistor MOS et une seconde borne est destinée à être polarisée, des moyens pour imposer un potentiel au drain du second transistor MOS de la paire puis pour le laisser varier de manière à ce que le flux injecté au point commun se stocke sur la capacité de stockage tout en diminuant dans le second transistor MOS au bénéfice du premier. La tension à recopier est appliquée entre la grille du premier transistor MOS et une référence, la tension recopiée étant disponible, après stabilisation, entre la première borne de la capacité de stockage et la référence.

Les moyens pour injecter le flux d'électrons seront de préférence réalisés par un transistor MOS.

Les moyens pour imposer le potentiel seront de préférence réalisés par un interrupteur dont une extrémité est reliée à la première borne de la capacité de stockage et dont l'autre est destinée à être polarisée.

Pour accélérer le temps de recopie, on peut prévoir des moyens pour réguler l'injection d'électrons au point commun, en fonction du flux d'électrons circulant dans le premier transistor MOS de la paire. Il est possible d'ajouter des moyens de traitement de la tension recopiée de manière à pouvoir en disposer avec une impédance plus faible que celle qu'elle a lorsqu'elle est prélevée au niveau la capacité de stockage.

Il peut être avantageux de prévoir des moyens pour conserver une même valeur à la tension recopiée alors que la tension à recopier a changé de valeur.

D'autres caractéristiques et avantages de la présente invention apparaîtront à la lecture de la description de divers modes de réalisation faite ci-après avec référence aux dessins annexés qui représentent :

- la figure 1 un schéma d'un dispositif de recopie de tension connu ;
- la figure 2 un schéma d'un exemple d'un dispositif de recopie de tension selon l'invention ;
- les figures 3a, 3b, 3c, 3d l'évolution des potentiels de canal dans le substrat dans lequel est intégré le dispositif de la figure 2 à quatre instants successifs;
- la figure 4 un schéma d'un exemple d'un dispositif de recopie de tension selon l'invention plus rapide que celui de la figure 2;
- la figure 5 un schéma d'une variante de l'exemple de la figure 4;
- la figure 6 un schéma d'un exemple d'un dispositif selon l'invention fournissant la tension recopiée sous basse impédance;
- la figure 7 les potentiels de canal dans le substrat pour un dispositif conforme à celui de la figure 6, lorsque la tension recopiée est disponible;
- la figure 8 un schéma d'une variante du schéma de la figure 6 avec un temps de recopie réduit;
- les figures 9a et 9b deux schémas d'un dispositif selon l'invention permettant de conserver la tension recopiée si la tension à recopier varie.

Sur les figures, les mêmes références désignent les mêmes éléments. Pour des raisons de clarté les côtes et proportions des éléments ne sont pas respectées.

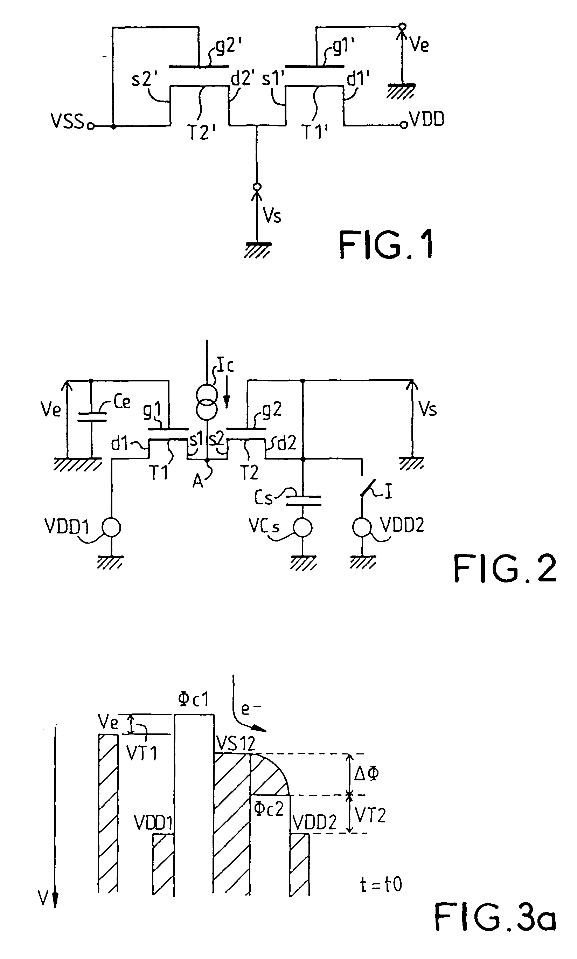

La figure 1a représente un dispositif de recopie de tension à transistors MOS de type connu. Ce dispositif comporte deux transistors MOS T1', T2' montés en série, les deux transistors ont un point commun entre le drain d2' du transistor T2' et la source s1' du transistor T1'. Ces transistors sont destinés à être alimentés: la source s2' du transistor T2' est portée au potentiel VSS et le drain d1' du transistor T1' au potentiel VDD. Le potentiel VSS est inférieur au potentiel VDD.

Le transistor T1' est dit suiveur, il reçoit entre sa grille g1' et une référence la tension à recopier Ve. Le transistor T2' est dit de charge, sa grille g2' est connectée à sa source s2'. La tension recopiée Vs est prélevée entre le point commun des deux transistors MOS T1', T2' et la référence.

Dans le schéma de la figure 1, on suppose que le transistor MOS T2' possède une implantation de canal telle que sa tension de seuil VT2 soit négative.

Son potentiel de canal $\phi 2$ se définit par la relation suivante :

$$\phi 2 = VG2 - VT2$$

avec VG2 sa tension de grille.

Son courant I2' est donné par la relation :

$$I2' = \frac{1}{2} \mu \, Cox_2 \left(\frac{W2}{L2}\right)(\phi 2 - VSS)^2$$

ou

$$I2' = \frac{1}{2} \mu \, Cox_2 \frac{W2}{L2} VT2^2$$

avec:

- $\mu$ mobilité des électrons dans le canal
- $Cox_2$ capacité surfacique de l'isolant grille du transistor MOS T2'
- W2 largeur du transistor MOS T2'
- L2 longueur du transistor MOS T2'.

Un courant I1' égal à I2' circule dans le transistor MOS T1'

$$I1' = \frac{1}{2} \mu \, Cox_1 \frac{W1}{L1} (\phi 1 - VS1)^2.$$

avec:

- $Cox_1$ capacité surfacique de l'isolant grille du transistor MOS T1'
- W1 largeur du transistor MOS T1'
- L1 longueur du transistor MOS T1'
- $\phi 1$ potentiel de canal du transistor MOS T1' avec $\phi 1$ = VG1 - VT1, VG1 étant sa tension de grille, VT1 sa tension de seuil.
- VS1 tension de source du transistor MOS T1'.

$$I1' = \frac{1}{2} \mu \, Cox_1 \frac{W1}{L1} (VG1 - VT1 - VS1)^2.$$

$$I1' = \frac{1}{2} \mu \, Cox_1 \frac{W1}{L1} (Ve - VT1 - Vs)^2$$

Puisque I1' = I2'

$$(Ve - VT1 - Vs)^2 = \frac{\frac{1}{2}\mu Cox_2 \frac{W2}{L2}}{\frac{1}{2}\mu Cox_1 \frac{W1}{L1}} \cdot VT2^2$$

Le terme

$$\frac{\frac{1}{2}\mu Cox_2 \frac{W2}{L2}}{\frac{1}{2}\mu Cox_1 \frac{W1}{L1}} \cdot VT2^2$$

est indépendant de Ve et de Vs, il est constant. Posons le égal à $K^2$, on tire Vs = Ve - K - VT1

Au premier ordre, VT1 est une constante mais au deuxième ordre VT1 est une fonction de Ve. Le circuit de la figure 1 introduit une non linéarité entre Vs et Ve.

La figure 2 représente un exemple d'un dispositif de recopie de tension conforme à l'invention.

Ce dispositif comporte une paire de transistors MOS T1, T2 ayant leurs sources s1 et s2 reliées en un point commun A. La tension à recopier Ve est appliquée entre la grille g1 du premier transistor MOS T1 et une référence. La grille g2 et le drain d2 du second transistor MOS T2 sont reliés. Le drain d2 du second transistor MOS T2 est également relié à une première borne d'une capacité de stockage Cs. La seconde borne de la capacité de stockage Cs est destinée à être polarisée par une tension VCs. Des moyens Ic sont prévus pour injecter un flux d'électrons au point commun A.

Des moyens I sont prévus pour, dans un premier temps, imposer le potentiel Vd2 du drain d2 du second transistor MOS T2, puis dans un deuxième temps, le laisser varier. La tension recopiée Vs est prélevée entre la première borne de la capacité de stockage Cs et la référence.

Le drain d1 du premier transistor MOS T1 est destiné à recevoir une tension de polarisation VDD1.

Les moyens I pour imposer le potentiel puis le laisser varier peuvent être réalisés par un interrupteur I ayant une première borne reliée au drain d2 du second transistor MOS T2 de la paire et une seconde borne destinée à recevoir une tension de polarisation VDD2 imposant le potentiel Vd2. Dans la pratique, l'interrupteur I pourra être formé d'un transistor MOS par exemple. Les tensions de polarisation VDD1 et VDD2 sont supérieures au potentiel de canal engendré par Ve dans le transistor MOS T1 et à la tension présente au point commun A.

Les tensions VDD2, VDD1 et VCs peuvent être fournies par trois sources d'alimentation distinctes mais dans la pratique, il est préférable d'en utiliser moins, une seule source d'alimentation peut convenir pour fournir les trois tensions de polarisation.

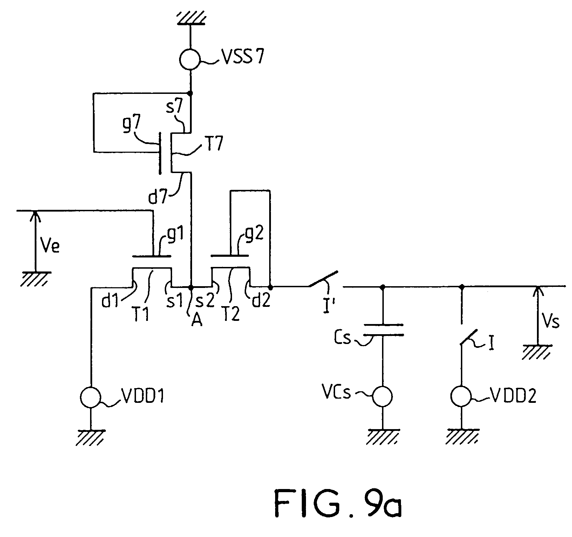

Les moyens Ic pour injecter le flux d'électrons au point commun A peuvent être réalisés, par exemple par un transistor MOS comme la figure 9a décrite ultérieurement le montre.

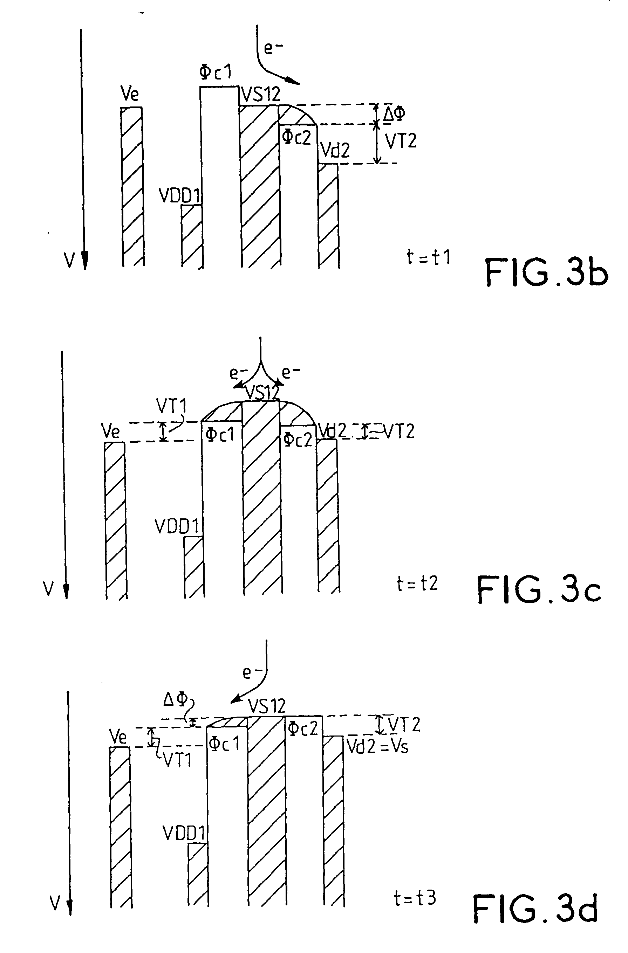

Les figures 3a, 3b, 3c, 3d montrent l'évolution des potentiels de canal dans le substrat dans lequel est intégré le dispositif selon l'invention.

La figure 3a se situe au temps to, à cet instant l'interrupteur I est passant. Le potentiel Vd2 du drain d2 du transistor MOS T2 est imposé et égal à VDD2. Les électrons injectés au point commun A traversent le transistor MOS T2.

Le potentiel de canal $\phi c1$ du transistor MOS T1 se définit par : $\phi c1$ = Ve - VT1    VT1 est la tension de seuil du transistor MOS T1.

La figure 3b se situe au temps t1. A cet instant l'interrupteur I est bloqué. Le potentiel Vd2 peut varier. La capacité de stockage Cs se charge grâce au flux d'électrons qui traverse le transistor MOS T2. Le potentiel Vd2 diminue.

La figure 3c se situe au temps t2. A cet instant, le flux d'électrons injecté au point commun A se répartit entre les deux transistors MOS T1 et T2. Le potentiel Vd2 continue à décroître et de moins en moins d'électrons traversent le transistor MOS T2.

La figure 3d se situe au temps t3 qui est le temps final. Tout le flux d'électrons injecté au point commun A traverse le transistor MOS T1 et le transistor MOS T2 est bloqué. La tension Vs recopiée est disponible entre la première borne de la capacité de stockage Cs et la référence. Elle correspond au potentiel Vd2 du drain d2 du transistor MOS T2 si la référence est la masse.

$$Vs = Ve - VI1 - \Delta\phi + VT2$$

$$\Delta\phi = \phi c2 - VS12$$

avec : VS12 le potentiel du point commun A. La tension $\Delta\phi$ dépend de la source Ic qui injecte les électrons. Elle ne dépend pratiquement pas de Ve. Elle peut être rendue négligeable si les deux transistors MOS T1, T2 sont choisis tels que leur rapport largeur sur longueur est grand.

Les deux transistors MOS T1, T2 sont choisis aussi semblables que possible, ils sont proches l'un de l'autre. Ils sont soit non implantés (type nature), soit implantés avec une impureté de type P. Dans ces cas, leurs tensions de seuil respectives VT1 et VT2 sont positives.

Au temps t3, la différence entre les potentiels de canal des deux transistors MOS est égale à $\Delta\phi$. Si $\Delta\phi$ est petit, on peut admettre que leurs tensions de seuil VT2, VT1 sont sensiblement égales quelle que soit la tension à recopier Ve. Il en résulte que la tension recopiée Vs est sensiblement égale à la tension à recopier Ve.

La relation qui lie Vs et Ve est indépendante de la valeur de la capacité de stockage Cs. Si l'on souhaite obtenir la tension Vs sous forte impédance, il suffit de choisir Cs grand. Dans les dispositifs de lecture de charges engendrées dans une matrice ou une barrette photosensibles, la tension d'entrée Ve à recopier est définie par une quantité de charges Qe stockée sur une capacité Ce. Il est possible de choisir la valeur de la capacité de stockage Cs de la tension recopiée Vs supérieure à la valeur de la capacité de stockage Ce de la tension à recopier Ve.

Avec le dispositif de la figure 2, la tension recopiée Vs n'est pas obtenue instantanément car le temps pendant lequel le flux d'électrons se partage entre les deux transistors MOS T1, T2 n'est pas négligeable. En fait ce temps est très long pour que plus aucun électron ne passe dans le transistor MOS T2. Juste après le blocage de l'interrupteur I, le potentiel Vd2 décroît très rapidement mais ensuite il décroît beaucoup plus lentement.

Dans la pratique, on attendra quelques microsecondes après le blocage de l'interrupteur I avant de considérer que le flux d'électrons dans le transistor MOS T2 s'est tari et que la tension recopiée Vs est disponible. Ce temps peut être trop long dans certaines applications. Par exemple, dans une matrice photosensible de 1000 lignes fonctionnant à 30 Hz et dont le temps de lecture d'une ligne est de 30 µs attendre 3µs pour disposer de la tension recopiée est juste tolérable. On perd 10 % du temps.

Par contre si la matrice comporte 2000 lignes ou plus un temps de 3 µs est trop long.

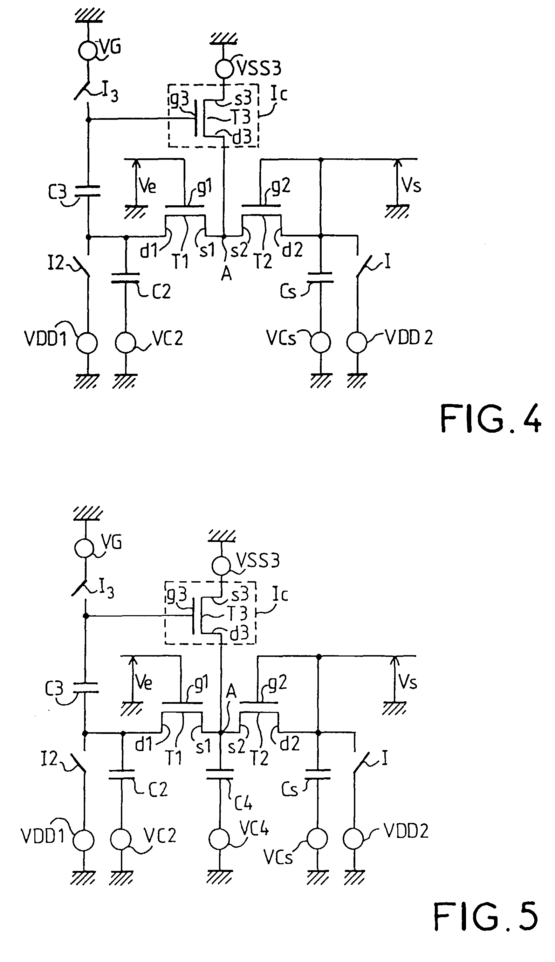

Le schéma de la figure 4 représente une variante du schéma de la figure 2. Le temps nécessaire pour la recopie a été diminué.

Cette variante prévoit des moyens pour réguler le flux d'électrons injecté au point commun A afin qu'il diminue lorsque le flux d'électrons traversant le premier transistor MOS T1 de la paire augmente.

Ces moyens comportent des premiers moyens supplémentaires I2 qui imposent dans un premier temps un potentiel Vd1 sur le drain d1 du premier transistor MOS T1. Dans un deuxième temps, ces premiers moyens supplémentaires I2 le laissent varier de manière à ce que le flux d'électrons circulant dans le premier transistor MOS T1 se stocke sur une deuxième capacité de stockage C2 dont une première borne est reliée au drain d1 du premier transistor MOS T1 et dont une seconde borne est destinée à être polarisée par une tension VC2. Ces premiers moyens supplémentaires comportent un premier interrupteur supplémentaire I2 dont une extrémité est reliée au drain d1 du premier transistor MOS T1 et dont l'autre extrémité est destinée à recevoir une tension de polarisation VDD1 imposant le potentiel Vd1.

Ces moyens comportent aussi des seconds moyens supplémentaires I3, C3 pour initialiser dans un premier temps l'injection d'électrons au point commun A puis pour la diminuer en fonction de la diminution du potentiel Vd1 sur le drain du premier transistor MOS T1. Lorsque les moyens Ic pour injecter le flux d'électrons au point commun A sont formés d'un transistor MOS T3 dont le drain d3 est connecté au point commun A, les seconds moyens supplémentaires I3, C3 imposent dans un premier temps un potentiel Vg sur la grille g3 du transistor MOS T3, pour initialiser l'injection d'électrons, puis dans un deuxième temps transmettent sur cette grille g3 la variation du potentiel du drain d1 du transistor MOS T1. Ces seconds moyens supplémentaires comportent un troisième interrupteur I3 et une troisième capacité C3. Le troisième interrupteur I3 a une extrémité qui est reliée à la grille g3 du transistor MOS T3 et l'autre extrémité qui est destinée à recevoir une tension de polarisation VG imposant le potentiel Vg. La troisième capacité C3 est montée entre le drain d1 du transistor MOS T1 et la grille g3 du transistor MOS T3. Elle sert à transmettre la variation de potentiel du drain d1. La source s3 du transistor MOS T3 est destinée à être polarisée par à une tension VSS3.

Ces moyens pour réguler le flux d'électrons injecté au point commun A permettent de diminuer le temps nécessaire pour la recopie. Le temps nécessaire pour la recopie dépend de la valeur de la capacité de stockage C2, plus elle est petite plus le temps est court.

Les tensions de polarisation VG et VSS3 sont choisies de manière à ce que le transistor MOS T3 soit en régime saturé lorsque le troisième interrupteur I3 est passant. Dans cette configuration : VG - VT3 - VSS3>0.

Une solution simple est de choisir VG et VSS3 identiques et nulles et de prendre un troisième transistor MOS T3 ayant une tension de seuil VT3 négative, c'est à dire un transistor MOS à canal enterré. D'autres choix pour VSS3, VG et VT3 sont bien sûr possibles.

Il est possible de fournir les tensions de polarisation VDD1, VDD2, VC2, VCs à partir d'une source de tension unique ou d'en utiliser plusieurs.

Le fonctionnement d'un tel circuit est le suivant :

A l'instant to, les interrupteurs I, I2,I3 sont tous passants. Les potentiels aux bornes des armatures des capacités Cs, C2, C3 sont fixés. Les potentiels Vd1, Vd2,Vg3 sont imposés. Le transistor MOS T3 fonctionne en source de courant et le flux d'électrons qu'il délivre au point commun A passe par le transistor MOS T2.

A l'instant t1, on bloque tous les interrupteurs I, I2, I3. Ce blocage peut être synchronisé pour les trois interrupteurs I, I2, I3 à l'aide d'une seule alimentation pulsée par exemple. Les potentiels Vd1, Vd2, Vg peuvent varier. Il peut être toutefois judicieux de bloquer les interrupteurs I2 et I3 l'un après l'autre pour ne pas perturber la troisième capacité C3. On peut bloquer l'interrupteur I en même temps que l'interrupteur I2 ou en même temps que l'interrupteur I3.

Le flux d'électrons délivré par le transistor MOS T3 passe par le transistor MOS T2 et s'intègre sur la capacité Cs en diminuant la tension drain Vd2 du transistor MOS T2 comme dans l'exemple de la figure 2.

A l'instant t2, le flux d'électrons délivré par le transistor MOS T3 commence à se répartir entre les deux transistors MOS T1, T2. Les électrons passant par le transistor MOS T1 s'intègrent sur la seconde capacité de stockage C2 et le potentiel drain Vd1 du transistor MOS T1 décroît. Cette baisse de potentiel est transmise par la troisième capacité C3 à la grille g3 du transistor MOS T3. Cette baisse de potentiel sur la grille g3 entraîne une diminution de la quantité d'électrons fournie au moint commun A. Le transistor MOS T3 finit par se bloquer et la tension Vs recopiée se stabilise. Cette stabilisation intervient plus vite que dans l'exemple de la figure 2.

La valeur maximale de Vs est de

$Vs\ max = Ve - VT1 + \Delta\phi + VT2$ si la valeur de la capacité C2 est petite, c'est à dire si la tension Vs est disponible dès que des électrons commencent à parcourir le transistor MOS T1.

La valeur minimale de Vs est de :

$Vsmin = Ve - VT1 - \Delta\phi + VT2$ si la valeur de la capacité C2 est grande. Pour des valeurs de C2 moyennes, la valeur de Vs sera comprise entre les deux valeurs maximales et minimales.

Dans tous les cas, pour une valeur de la capacité C2 donnée, la valeur de Vs et le temps nécessaire à son obtention seront stables et reproductibles d'une utilisation à une autre.

Le circuit de la figure 4, accélère un peu le temps nécessaire pour obtenir la tension Vs recopiée par rapport à celui de la figure 2. Mais puisque l'évolution du potentiel Vd1 du drain du transistor MOS T1 se ralentit lorsque le flux d'électrons injecté au point commun A décroît, et que c'est le potentiel Vd1 qui vise à commander le flux d'électrons injecté au point commun A, le transistor MOS T3 peut mettre un certain temps pour se bloquer.

La figure 5 illustre un exemple d'une variante d'un dispositif de recopie de tension selon l'invention encore plus rapide.

Une capacité tampon C4 a été ajoutée par rapport au schéma de la figure 4. Cette capacité tampon C4 a une borne reliée au point commun A et l'autre borne destinée à être polarisée par une tension VC4. Cette tension VC4 peut être fournie par la source de tension unique qui fournit VDD2, VDD1, VC2, VCs ou par une autre source de tension.

Dans cette variante, lorsque le flux d'électrons, injecté au point commun A par le transistor MOS T3 diminue, les flux qui se répartissent dans les transistors MOS T1 et T2 ne diminuent pas instantanément car la capacité tampon C4 maintient sensiblement constant le potentiel VS12 du point commun A

Le flux d'électrons passant à travers le transistor MOS T1 continue à s'intégrer sur la capacité C2 et le transistor MOS T3 se bloque plus rapidement.

Dans tous les exemples décrits précédemment la tension recopiée Vs est disponible sous impédance forte car elle est fournie par une quantité de charges stockée sur la capacité de stockage Cs.

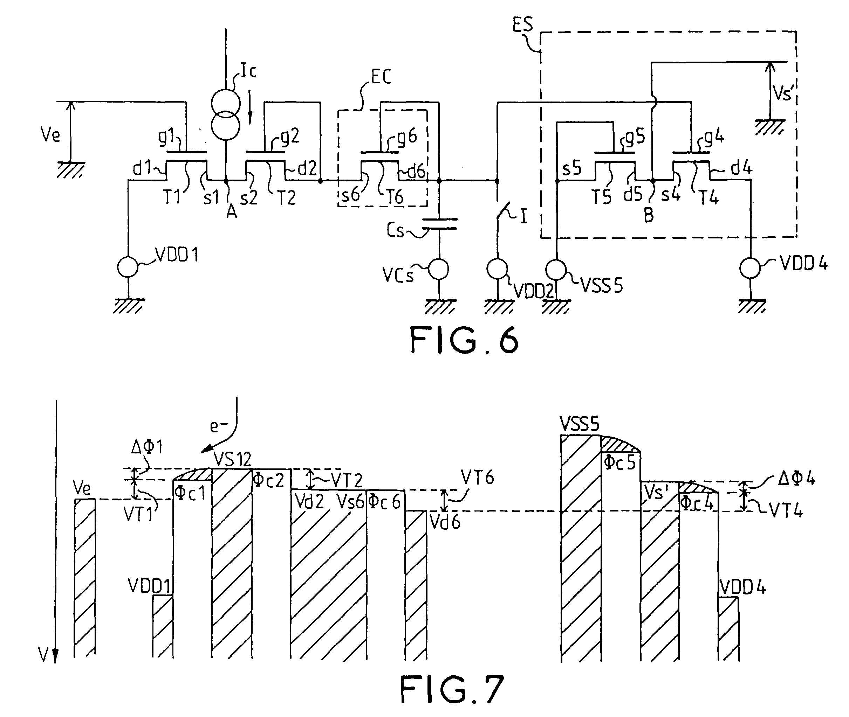

Dans certaines applications, il peut être intéressant de disposer d'une tension recopiée non pas sous une forte impédance mais sous une impédance plus faible. C'est ce qu'illustre le schéma de la figure 6 qui représente un autre exemple de dispositif de recopie de tension selon l'invention.

Des moyens de traitement de la tension recopiée permettant de la fournir avec une impédance plus faible ont été ajoutés au schéma de la figure 2.

Ces moyens de traitement comportent un étage suiveur ES connecté à la première borne de la capacité de stockage Cs et un étage de compensation EC. L'étage suiveur ES fournit la tension recopiée Vs' sous basse impédance et l'étage de compensation EC compense un inévitable décalage en tension introduit par l'étage suiveur ES. L'étage de compensation EC est connecté entre la première borne de la capacité de stockage Cs et la paire de transistors MOS T1,T2.

L'étage de compensation EC est réalisé dans cet exemple par un seul transistor MOS T6 dont la source s6 est connectée au drain d2 du transistor MOS T2 et dont le drain d6 est connecté à la première borne de la capacité de stockage Cs. La grille g6 du transistor MOS T6 est reliée à son drain d6.

L'étage suiveur ES est réalisé à base de deux transistors MOS T4, T5. Les deux transistor MOS T4 T5 ont un point commun B entre la source s4 du transistor MOS T4 et le drain d5 du transistor MOS T5. La tension recopiée Vs', sous impédance diminuée, est prélevée entre le point commun B aux deux transistors MOS T4, T5 et la référence.

La grille g4 du transistor MOS T4 est connectée à la première borne de la capacité de stockage Cs. La grille g5 et la source s5 du transistor MOS T5 sont reliées et sont destinées à être polarisées par une tension VSS5. Le drain d4 du transistor MOS T4 est destiné à être polarisé par une tension VDD4.

La figure 7 représente les potentiels de canal dans le substrat dans lequel est intégré le dispositif selon l'invention au temps final lorsque le transistor MOS T2 est bloqué. La tension Vd6 prélevée entre la première borne de la capacité de stockage Cs et la référence est donnée par:

$$Vd6 = Ve - VT1 - \Delta\phi1 + VT2 + VT6$$

Ici encore on peut admettre que les tensions de seuil VT1 et VT2 sont très proches l'une de l'autre quelle que soit la tension Ve, si les deux transistors MOS T1, T2 sont proches l'un de l'autre et aussi semblables que possibles.

La tension recopiée Vs' peut s'écrire sous la forme :

$$Vs'= Vd6 - VT4 - \Delta\phi4$$

ou

$$Vs' = Ve - \Delta\phi1 + VT6 - VT4 - \Delta\phi4$$

Ici aussi on peut admettre que les tensions de seuil VT6 et VT4 sont très proches l'une de l'autre, si les transistors MOS T4 et T6 sont proches l'un de l'autre et aussi semblables que possible :

$$Vs'= Ve - \Delta\phi1 - \Delta\phi4$$

Les tensions $\Delta\phi1$ et $\Delta\phi4$ sont indépendantes de Ve et peuvent être rendues petites si les transistors MOS T1, T2, T4, T6 ont un rapport W/L relativement grand. L'étage suiveur ES a introduit un décalage de tension VT4 et l'étage de compensation EC un décalage VT6 mais ces deux décalages s'annihilent.

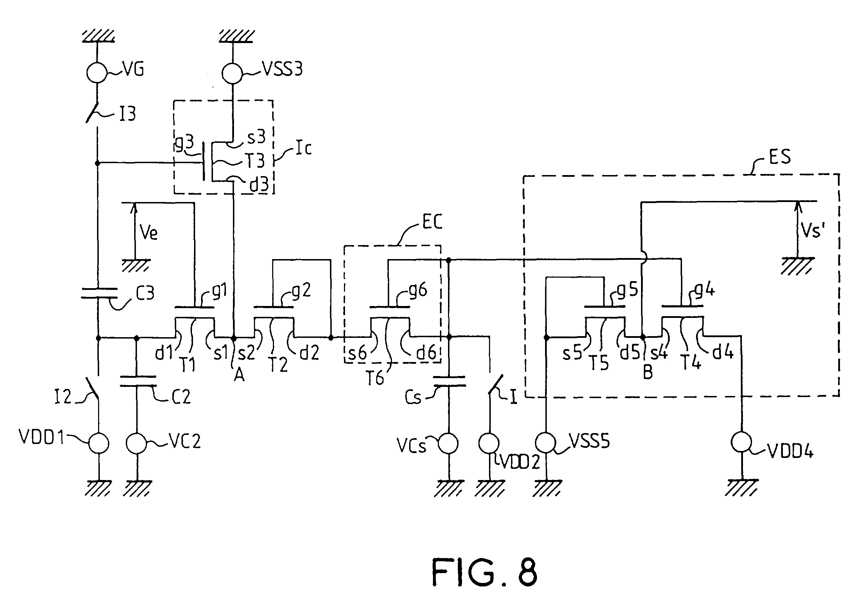

Il peut être intéressant de disposer de la tension recopiée Vs' sous basse impédance rapidement. La figure 8 illustre le cas d'un tel dispositif. Ce dispositif combine le dispositif de la figure 5 et celui de la figure 6.

Il peut être judicieux de continuer à disposer de la tension recopiée alors que la tension à recopier à changé de valeur. Par exemple dans le cas de la lecture de charges d'une colonne d'une matrice photosensible, il peut être utile de disposer de la tension recopiée provenant d'une première lecture alors que la tension à recopier provient déjà d'une seconde lecture.

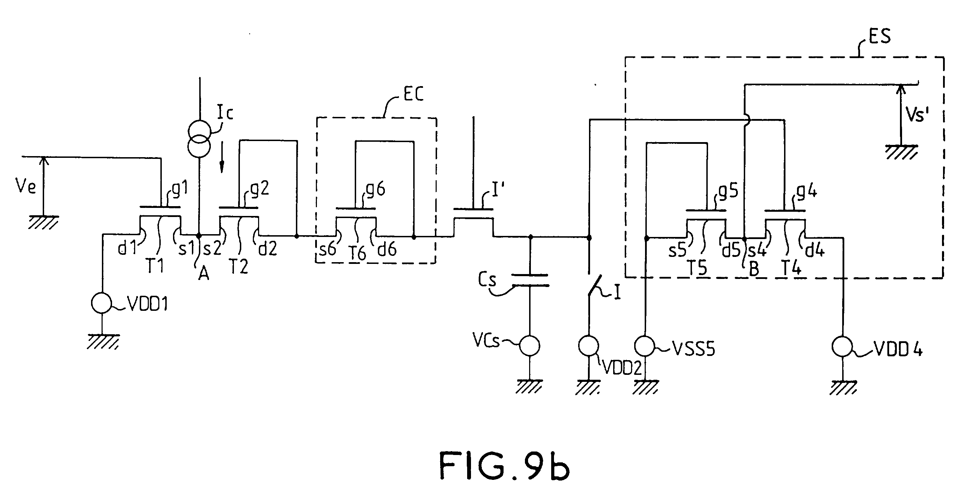

Les schémas des figures 9a et 9b illustrent cette variante. La tension recopiée est disponible sous forte impédance sur la figure 9a et sous impédance plus faible sur la figure 9b.

Des moyens aptes à interrompre temporairement la liaison entre la première borne de la capacité de stockage Cs et la paire de transistors MOS T1, T2 sont prévus. Sur la figure 9a, la première borne de la capacité de stockage Cs est reliée au drain d2 du transistor MOS T2 par l'intermédiaire d'un interrupteur I'. Lorsque l'interrupteur I' est passant le flux d'électrons injecté au point commun A peut charger la capacité Cs. Dès que la capacité Cs est chargée et que la tension recopiée Vs est disponible, le blocage de l'interrupteur I' permet de pouvoir continuer à disposer de la tension Vs sans subir l'influence du circuit amont notamment sans être influencé par une modification de la tension Ve à recopier.

Sur la figure 9a, les moyens Ic pour injecter le flux d'électrons au point commun A comporte un transistor MOS T7 dont le drain d7 est relié au point commun A, dont la source s7 est destinée à être polarisée par une tension VSS7 et dont la grille g7 est reliée à la source s7. Ceci suppose que la tension seuil du transistor MOS T7 est négative.

La figure 9b est comparable à celle de la figure 6 mais l'interrupteur I'a été ajouté entre le drain d6 du transistor T6 et la première borne de la capacité de stockage Cs. Cet interrupteur I' est représenté sous la forme d'un transistor MOS. L'actionnement de l'interrupteur peut s'effectuer en commandant la tension appliquée sur sa grille.

D'autres implantations auraient été possibles pour l'interrupteur I', par exemple entre le drain d2 du transistor MOS T2 de la paire et la source du transistor MOS T6.

Les moyens aptes à interrompre temporairement la liaison entre la première borne de la capacité de stockage Cs et la paire de transistors MOS T1, T2 peuvent être introduits dans les variantes conduisant à une réduction de temps de recopie.

Tous les transistors MOS représentés et décrits dans ce qui précède sont de type N mais l'homme de l'art pourra aisément faire la transposition en transistors MOS de type P.

**Revendications**

1. Dispositif de recopie d'une tension (Ve) comportant une paire de transistors MOS (T1,T2) en série, la tension à recopier (Ve) étant appliquée entre la grille (g1) du premier transistor MOS (T1) et une référence, caractérisé en ce qu'il comporte :

    - des moyens (Ic) pour injecter un flux d'électrons en un point (A) commun aux sources (s1,s2) des deux transistors MOS (T1,T2),

- une capacité de stockage (Cs) dont une première borne est reliée au drain (d2) du second transistor MOS (T2) et une seconde borne est destinée à être polarisée,

- des moyens (I) pour imposer un potentiel (Vd2) au drain (d2) du second transistor MOS (T2) puis pour le laisser varier de manière à ce que le flux d'électrons se stocke sur la capacité de stockage (Cs) tout en diminuant dans le second transistor MOS (T2) au bénéfice du premier (T1), la tension recopiée (Vs) étant disponible, après stabilisation, entre la première borne de la capacité de stockage (Cs) et la référence.

2. Dispositif de recopie de tension selon la revendication 1, caractérisé en ce que les moyens (Ic) pour injecter le flux d'électrons au point commun (A) comportent un transistor MOS (T7) dont le drain (d7) est relié au point commun (A), dont la grille (g7) et la source (s7) reliées ensemble sont destinées à être polarisés.

3. Dispositif de recopie de tension selon l'une des revendications 1 ou 2, caractérisé en ce que les moyens (I) pour imposer le potentiel (Vd2) comportent un interrupteur (I) dont une extrémité est reliée à la première borne de la capacité de stockage (Cs) et l'autre est destinée à être polarisée.

4. Dispositif de recopie de tension selon l'une des revendications 1 à 3, caractérisé en ce qu'il comporte des moyens (I2, I3, C3) pour réguler l'injection d'électrons en fonction du flux d'électrons circulant dans le premier transistor MOS (T1) de manière à accélérer la recopie.

5. Dispositif de recopie de tension selon la revendication 4, caractérisé en ce que ces moyens (I2, I3, C3) comprennent:

- des premiers moyens supplémentaires (I2) pour imposer tout d'abord un potentiel (Vd1) au drain (d1) du premier transistor MOS (T1) puis pour le laisser varier de manière à ce que des électrons circulant dans le premier transistor MOS (T1) se stockent sur une seconde capacité (C2) de stockage dont une première borne est reliée au drain (d1) du premier transistor MOS (T1) et dont une seconde borne est destinée à être polarisée,

- des seconds moyens supplémentaires (I3, C3) pour initialiser l'injection d'électrons puis pour la diminuer en fonction de la variation du potentiel (Vd1) du drain (d1) du premier transistor MOS (T1).

6. Dispositif de recopie de tension selon la revendication 5, caractérisé en ce que les premiers moyens supplémentaires (I2) comprennent un interrupteur (I2) ayant une extrémité reliée au drain (d1) du premier transistor MOS (T1) et une autre extrémité destinée à recevoir une tension de polarisation (VDD1) imposant le potentiel (Vd1).

7. Dispositif de recopie de tension selon l'une des revendications 5 ou 6, caractérisé en ce que, lorsque les moyens (Ic) pour injecter le flux d'électrons comportent un transistor MOS (T7), les seconds moyens supplémentaires (I3, C3) comportent :

- un troisième interrupteur (I3) ayant une première extrémité reliée à la grille (g7) du transistor MOS (T7) et une seconde extrémité destinée à recevoir une tension de polarisation (VG) visant à initialiser l'injection d'électrons lorsque l'interrupteur (I3) est passant;

- et une troisième capacité (C3) montée entre la grille (g7) du transistor MOS (T7) et le drain (d1) du premier transistor MOS (T1) de la paire, cette troisième capacité (C3) transmettant la variation du potentiel (Vd1) du drain (d1) du premier transistor MOS (T1) sur la grille (g7) du transistor MOS (T7) lorsque l'interrupteur (I3) est bloqué.

8. Dispositif de recopie de tension selon l'une des revendications 1 à 7, caractérisé en ce que les moyens (I) pour imposer un potentiel, les premiers moyens supplémentaires (I2) et les seconds moyens supplémentaires (I3, C3) sont synchronisés.

9. Dispositif de recopie de tension selon l'une des revendications 1 à 7, caractérisé en ce que les premier et second moyens supplémentaires (I2), (I3, C3) sont désynchronisés.

10. Dispositif de recopie de tension selon la revendication 9, caractérisé en ce que les moyens (I) pour imposer un potentiel sont synchronisés avec soit le premier moyen supplémentaire (I2), soit le second moyen supplémentaire (I3, C3).

11. Dispositif de recopie de tension selon l'une des revendications 4 à 10, caractérisé en ce qu'il comporte une capacité tampon (C4) ayant une première borne reliée au point commun (A) et une seconde borne destinée à être polarisée, cette capacité tampon (C4) accélérant encore la recopie.

12. Dispositif de recopie de tension selon l'une des revendications 1 à 11, caractérisé en ce qu'il comporte des moyens (EC, ES) pour traiter la tension recopiée (Vs') de manière à diminuer son impédance.

13. Dispositif de recopie de tension selon la revendication 12, caractérisé en ce que ces moyens de traitement comportent un étage suiveur (ES) relié à la première borne de la capacité de stockage (Cs), fournissant la tension recopiée (Vs') sous basse impédance et un étage de compensation (EC) pour compenser un décalage de tension introduit par l'étage suiveur (ES), connecté entre la première borne de la capacité de stockage (Cs) et la paire de transistor MOS (T1,T2).

**14.** Dispositif de recopie de tension selon la revendication 13, caractérisé en ce que l'étage suiveur (ES) comporte deux transistors MOS (T4,T5) ayant un point commun (B) entre la source (s4) du premier transistor MOS (T4) et le drain (d5) du second transistor MOS (T5), la grille (g4) du premier transistor MOS (T4) étant reliée à la première borne de la capacité de stockage (Cs), la source (s5) du second transistor MOS (T5), connectée à sa grille (g5) étant destinée à être polarisée, la tension recopiée (Vs') étant prélevée entre le point commun (B) et la référence.

**15.** Dispositif de recopie de tension selon l'une des revendications 13 ou 14, caractérisé en ce que l'étage de compensation (EC) comporte un transistor MOS (T6) dont la source (s6) est connectée au drain (d2) du second transistor MOS (T2) de la paire, et dont la grille (g6) et le drain (d6) sont connectés à la première borne de la capacité de stockage (Cs).

**16.** Dispositif de recopie de tension selon l'une des revendications 1 à 15, caractérisé en ce qu'il comporte des moyens (I') pour conserver une même valeur à la tension recopiée (Vs) en présence de variation de la valeur de la tension à recopier (Ve).

**17.** Dispositif de recopie de tension selon la revendication 15, caractérisé en ce que ces moyens comportent un interrupteur (I') pour interrompre temporairement la liaison entre la première borne de la capacité de stockage (Cs) et la paire de transistors MOS (T1,T2) lorsque la tension recopiée (Vs) est disponible.

**18.** Circuit de recopie de tension selon l'une des revendications 4 à 17, caractérisé en ce qu'au moins un des interrupteurs (I, I2, I3, I') est réalisé par un transistor MOS.

**19.** Circuit de recopie de tension selon l'une des revendications 1 à 17 caractérisé en ce que les transistors MOS (T1, T2) de la paire sont aussi semblables que possible.

**20.** Circuit de recopie de tension selon l'une des revendications 13 ou 14, caractérisé en ce que le transistor MOS (T6) de l'étage de compensation (EC) et le premier transistor MOS (T4) de l'étage suiveur (ES) sont aussi semblables que possible.

FIG.1

FIG.2

FIG.3a

FIG.3b

t = t1

FIG.3c

t = t2

FIG.3d

t = t3

FIG.4

FIG.5

FIG.6

FIG.7

EP 0 731 557 A1

FIG. 8

FIG. 9a

FIG.9b

EP 0 731 557 A1

**Office européen des brevets**

## RAPPORT DE RECHERCHE EUROPEENNE

Numero de la demande

EP 96 40 0347

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US-A-3 986 176 (WEIMER)<br><br>* abrégé; figures 4,6,12 *<br>--- | 1,4,11, 13 | H03F3/50 |
| A | US-A-4 247 919 (WHITE,JR. ET AL.)<br>* abrégé; figure 2 *<br>--- | 1 | |
| A | DE-A-43 25 362 (MITSUBISHI DENKI K.K.)<br>* figures 5,9 *<br>* page 5, ligne 34 - ligne 40 *<br>--- | 11 | |
| A | US-A-4 138 666 (EICHELBERGER ET AL.)<br>* abrégé; figure 1 *<br>* colonne 3, ligne 34 - ligne 38 *<br>--- | 14 | |
| A | US-A-3 900 743 (WEIMER)<br>* le document en entier *<br>----- | | |

| DOMAINES TECHNIQUES RECHERCHES (Int.Cl.6) |
|---|
| H03F<br>G11C<br>H01L |

Le présent rapport a été établi pour toutes les revendications

| Lieu de la recherche | Date d'achèvement de la recherche | Examinateur |
|---|---|---|
| BERLIN | 11 Juin 1996 | Danielidis, S |